# EUROPÄISCHE PATENTANMELDUNG

(11) **EP 2 421 157 A1**
(43) Veröffentlichungstag der Anmeldung: **22.02.2012**
(21) Anmeldenummer: 11172455.5
(22) Anmeldetag: 04.07.2011
(51) Int. Cl.: H03M 3/04, H03M 3/02

(54) **Verfahren zum Betreiben eines Delta-Sigma-Wandlers**

(30) Priorität: 29.07.2010 DE 102010038670
(71) Anmelder: SEMIKRON Elektronik GmbH & Co. KG, 90431 Nürnberg (DE)
(72) Erfinder: Königsmann, Gunter, 91058 Erlangen (DE)

(57) **Zusammenfassung**

Bei einem Verfahren zum Betreiben eines Delta-Sigma-Wandlers (2), der einen mehrere Bit breiten Digitalwert (W) in Taktzyklen (T₁,...) in einen binäre Signalzustände (Lo,Hi) aufweisenden Bitstrom (4) wandelt, und die Signalzustände (Lo,Hi) in den Taktzyklen (T₁,...) nach einem Delta-Sigma-Verfahren mit integrierender Speicherung eines Restfehlers (F) gewählt werden:
- wird nach jedem durch das Delta-Sigma-Verfahren verursachten Wechsel des Signalzustandes (Lo,Hi):
- ein eventueller weiterer, durch das Delta-Sigma-Verfahren geforderter Wechsel des Signalzustandes (Lo,Hi) für mindestens eine vorgebbare Anzahl (n) von Taktzyklen (T₁,...) unterdrückt,
- wird der auflaufende Restfehler (F) weiter integriert.

## Beschreibung

Die Erfindung betrifft ein Verfahren zum Betreiben eines Delta-Sigma-Wandlers.

Für die Erzeugung eines Analogsignals, z.B. einer Analogspannung gibt es verschiedene Möglichkeiten: Beispielsweise können Widerstandsnetzwerke eingesetzt werden. Bei einer Realisierung solcher Widerstandsnetzwerke durch integrierte Schaltungen (IC, integrated circuit) bzw. Chips können derartige Widerstandsnetzwerke auch durch Kapazitätsnetzwerke ausgetauscht werden. Analogspannungen können auch durch einen PWM-Modulator erzeugt werden: Ein Ausgangsbitstrom des PWM-Modulators, der nur zwei Signalzustände einnehmen kann - Hi und Lo - wird auf ein Filter geführt und zu der Analogspannung geglättet. Eine ähnliche Variante ist die Verwendung eines Delta-Sigma-Wandlers, der einen alternativen Bitstrom erzeugt. Die beiden letzten Varianten beschreiben die Erzeugung eines Analogsignals durch eine digitale Endstufe. In der Leistungselektronik wird ein solches Verfahren z.B. zur Kalibrierung von Spannungen und Schaltquellen verwendet, im Endverbraucherbereich z.B. in Klasse D-Audio-Endstufen bzw. als 1-Bit-D/A-Wandler.

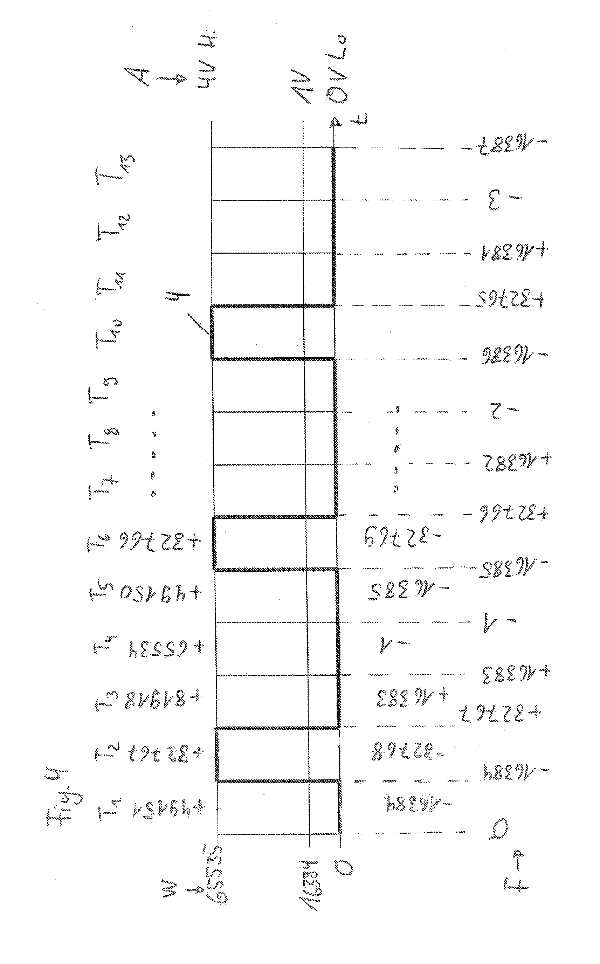

Ein bekannter Delta-Sigma-Wandler funktioniert nach folgendem Prinzip, das anhand Fig. 4 erläutert wird: Der zu erzeugende Analogwert A, z.B. eine Spannung von 1V wird zunächst als mehrere Bit breiter Digitalwert W vorgegeben. Der Digitalwert W ist hierbei der der Spannung entsprechende Wert, der z.B. linear zwischen einer maximalen (größter Wert) und einer minimalen (kleinster Wert) erzeugbaren Spannung liegt. Z.B. beträgt der kleinste Wert A=0V und der maximale Wert A=4V. Bei einem Digitalwert W mit sechzehn Bit Auflösung ergeben sich dann Digitalwerte W zwischen 0 (entsprechend 0V) und 2^{16_} 1=65535 (entsprechend 4V). Der Wert von A=1V entspricht dann einem Digitalwert W von 65535/4=16384.

Der Delta-Sigma-Wandler wandelt den Digitalwert in Taktzyklen T₁,... in einen lediglich die zwei Signalzustände Hi oder Lo einnehmenden Bitstrom 4. Die Signalzustände Hi, Lo werden gemäß dem Digitalwert W und den Vorschriften des Delta-Sigma-Verfahrens in den Taktzyklen T₁,... gewählt. Das Verfahren zeichnet sich durch eine integrierende Speicherung eines Restfehlers F aus. Eine dauernde Ausgabe eines Lo-Pegels repräsentiert beispielweise die digitale W=0 oder A=0V, eine Dauerausgabe des Hi-Pegels die digitale Größe W=65535 oder A=4V.

Für die Ausgabe von Zwischenwerten zwischen 0 und 65535 wird der Digitalausgang stets zwischen den beiden Schaltzuständen Hi und Lo nach folgender Vorschrift alterniert: Soll beispielsweise ein Wert von A=1V erzeugt werden, entsprechend einem Digitalwert von W=16384, entscheidet der Delta-Sigma-Wandler im ersten Taktzyklus T1, ob er ein Hi entsprechend dem Wert W=65535 oder ein Lo entsprechend dem Wert W=0 ausgeben werden soll.

Für jeden der beiden Fälle wird der potentielle zu machende Fehler F ermittelt. Im Falle des Lo-Pegels würde der Fehler F=0^{_}16384=^{_}16384 betragen, im Falle des Hi-Pegels F=65535^{_} 16384=+49151. Der Delta-Sigma-Wandler wählt dann den Signalpegel, bei dem der Betrag des Fehlers F minimal wird. Im ersten Taktzyklus T1 wird daher ein Lo ausgegeben. Der nun real aufgetretene Fehler von F=^{_}16384 wird als Restfehler gespeichert.

Im nächsten Taktzyklus T2 wird erneut entschieden, ob ein Hi oder Lo ausgegeben wird. Hierbei wird der bisher aufintegrierte Restfehler F beachtet. Bei erneuter Ausgabe von Lo würde sich der Restfehler auf F=^{_}16384+(0^{_}16384)=^{_}32768 addieren. Bei Ausgabe einer High ergibt der Restfehler F=^{_}16384+(65535^{_} 16384)=+32767. Da der letztere effektive Restfehler vom Betrag geringer ist, wird ein Hi im Taktzyklus T2 ausgegeben. Der integrierte Restfehler von F=+32767 wird gemerkt.

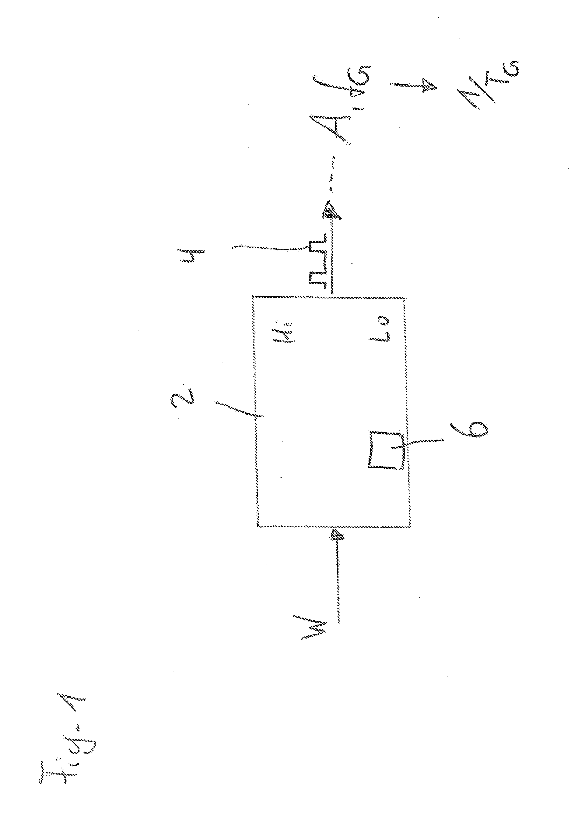

Im Dritten Takt T3 wird wiederum entscheiden, ob der aufintegrierte Restfehler F durch Ausgabe eines Lo oder eines Hi vom Betrag niedriger wird. Im Falle des Hi ergäbe sich +81918, im Falle von Lo +16383, also wird ein Lo ausgegeben. Der weitere Verlauf des Bitstroms 4 bis Takt T13 ist zusammen mit den potentiellen Fehlern und dem tatsächlichen Fehler F in Fig. 1 gezeichnet.

Das Ergebnis dieser Vorgehensweise ist ein Bitstrom bzw. Ausgangssignal, das im Durchschnitt genau den Wert besitzt, der dem Digitalwert entspricht, und damit nach entsprechender Mittelung bzw. Tiefpassfilterung dem gewünschten Analogwert. Der entsprechende jeweils auftretende Restfehler, welcher im Lauf der Erzeugung des Bitstroms aufintegriert wird, wird hierbei durch das Delta-Sigma-Verfahren vom Betrag so gering wie möglich gehalten. Der Vorteil ist folgender: Im Falle eines per Pulsweitenmodulation (PWM) betriebenen 16Bit-D/A-Wandlers würde dieser gegenüber dem Delta-Sigma-Wandler zunächst für 16384 Taktzyklen T1 bis T16384 ein Hi ausgeben und dann für 49152 Taktzyklen (T16385 bis T65536) ein Lo. Das nach einer Filterung erzeugte Analogsignal ist dadurch wellig mit einer minimalen Periode von etwa 16384 Taktzyklen.

Ein Delta-Sigma-Wandler erzeugt hingegen, wie in Fig. 4 zu sehen ist, ein Ausgangssignal welches in jedem vierten Taktzyklus seine Polarität wechselt. Der Bitstrom des Delta-Sigma-Wandlers ist also im Durchschnitt deutlich hochfrequenter, eine Filterung viel effektiver, so dass der ausgegebene Analogwert wesentlich besser ist als bei einer PWM. Die Oberwellen im erzeugten Analogsignal, die auch als Fehler bei der Analogausgabe verstanden werden können, sind bei einem Delta-Sigma-Wandler stets von unterschiedlicher Frequenz, je nach auszugebendem Digitalwert, beim PWM-Bitstrom liegen diese einheitlich bei der PWM-Frequenz.

Der Nachteil eines von einer PWM erzeugten Analogsignals bzw. hierbei generierten Fehlers liegt in dessen fester Frequenz. Zusätzlich muss die PWM mit einer besonders hohen Frequenz betrieben werden, um eine ausreichende Auflösung der Analogwerte bei ausreichend hoher Ausgangsfrequenz des Analogsignals zu erhalten. Insbesondere sehr hohe oder sehr niedrige Analogwerte können mit einer PWM in der Regel nicht zufriedenstellend erzeugt werden, wenn an einen PWM-Wandler keine Leistungsendstufe angeschlossen ist, die das Ausgangssignal zusätzlich verzögert. Ein Delta-Sigma-Wandler hingegeben eignet sich z.B. nicht für den direkten Anschluss an eine Audio-Endstufe, da z.B. bei einer Taktfrequenz des Delta-Sigma-Wandlers von 1MHz auch die Endstufentransistoren mit einer Schaltfrequenz von 1MHz schalten müssten.

Aufgabe der vorliegenden Erfindung ist es, ein verbessertes Verfahren zum Betreiben eines Delta-Sigma-Wandlers anzugeben. Die Aufgabe wird gelöst durch ein Verfahren gemäß Patentanspruch 1. Im erfindungsgemäßen Verfahren wird nach jedem durch das oben erläuterte Delta-Sigma-Verfahren verursachten Wechsel des Signalzustandes, also beim Übergang von Hi nach Lo oder umgekehrt, ein eventueller weiterer, durch das bekannte Delta-Sigma-Verfahren geforderter Wechsel des Signalzustandes für mindestens eine vorgebbare Anzahl n von Taktzyklen unterdrückt. Die Anzahl n ist hierbei mindestens zwei, also n≥2. Der hierbei auflaufende Restfehler wird jedoch weiterhin in jedem Taktzyklus aufintegriert. Signalwechsel im Bitstrom sind also jeweils nur im Abstand von mindestens n Taktzyklen erlaubt.

Mit anderen Worten wird im bekannten Delta-Sigma-Wandler-Verfahren verboten, den Ausgang, d.h. den Signalzustand, nach einer Änderung nach weniger als der vorgebbaren Anzahl n von Taktzyklen erneut umzuschalten, und so das bekannte Verfahren nur diesbezüglich erfindungsgemäß modifiziert. Bei der erfindungsgemäßen Realisierung des Delta-Sigma-Wandlers muss lediglich der verfügbare Fehlerspeicher gegenüber der bekannten Realisierung entsprechend vergrößert werden, um einen größeren Wertebereich an Fehlern speichern zu können, die auflaufen können.

Der bekannte Delta-Sigma-Wandler versucht daher nach wie vor, den jeweils zwischen gewünschtem und tatsächlichem Ausgangssignal auflaufenden Restfehler so gering wie möglich zu halten, lediglich mit der erfindungsgemäß modifizierenden Vorgabe, dass eine Mindestpulsdauer von n Taktzyklen pro Signalzustand eingehalten wird. Hierdurch werden die Vorteile einer PWM, nämlich eine beherrschbar niedrige Schaltfrequenz, und eines bekannten Delta-Sigma-Wandlers, nämlich ein niedriger durchschnittlicher Fehler und ein breites Spektrum des Fehlersignals, kombiniert.

Anzumerken ist, dass ab dem der Sperrung folgenden Taktzyklus wieder in jedem der folgenden Taktzyklen ein Signalwechsel stattfinden könnte, das Delta-Sigma-Verfahren also wieder unverändert ausgeführt wird. Dies ist ein wesentlicher Unterschied zu einem alternativen Delta-Sigma-Verfahren mit doppelter Zyklusdauer, da hier vergleichsweise nur an jedem zweiten Takt ein Signalwechsel erfolgen könnte, auch außerhalb der für Signalwechsel gesperrten Taktzyklen.

In einer bevorzugten Ausführungsform des Verfahrens wird die vorgebbare Anzahl n von Taktzyklen, in welchen ein Signalwechsel unterdrückt wird, so gewählt, dass deren kumulierte Dauer mindestens der halben minimalen Periodendauer eines aus dem Bitstrom erzeugten analogen Ausgangssignals beträgt.

Der Bitstrom wird in der Regel als analoges Zeitsignal bzw. Ausgangssignal, z.B. als zwischen zwei Werten wechselndes Spannungssignal ausgegeben. Für dieses Signal kann es gewünscht sein, eine minimale Periodendauer T_{G} ^{_} entsprechend einer maximalen Grenzfrequenz fg - vorzugeben. Mit anderen Worten soll das Ausgangssignal keine Signalwechsel in Zeitabständen kleiner der Periodendauer T_{G} beinhalten. Die Anzahl n wird dann so gewählt, dass eine Anzahl n von Taktzyklen T eine kumulierte Dauer n*T ergibt, die einer minimalen Pulsdauer im Bitstrom entspricht und die größer oder gleich der halben minimalen Periodendauer T_{G}/2 ist.

Gemäß dieser Vorschrift kann in einfacher Weise erreicht werden, dass das Delta-Sigma-Verfahren keinesfalls ein Analogsignal erzeugt, das signifikante Störanteile bei Frequenzen kleiner einer zur minimalen Periodendauer gehörenden Grenzfrequenz enthält.

Für eine weitere Beschreibung der Erfindung wird auf die Ausführungsbeispiele der Zeichnungen verwiesen. Es zeigen, jeweils in einer schematischen Prinzipskizze:
- Fig.1: einen Delta-Sigma-Wandler gemäß der Erfindung,
- Fig.2: ein Ausgangssignal des Delta-Sigma-Wandlers aus Fig. 1 für n=2 Taktzyklen mit unerlaubten Signalwechseln,
- Fig.3: ein alternatives Ausgangssignal gemäß Fig.2 für n=3,
- Fig.4: ein Ausgangssignal eines Delta-Sigma-Wandlers gemäß Stand der Technik.

Fig. 1 zeigt einen Delta-Sigma-Wandler 2, der mit einem Digitalwert W gespeist wird. Der Digitalwert W ist mehrerer Bit breit, im Beispiel sechzehn Bit, so dass dieser Werte W zwischen 0 und 65535 annehmen kann. Der Delta-Sigma-Wandler 2 gibt einen Bitstrom 4 in Form eines Logiksignals aus, welches nur zwei binäre Signalzustände Hi oder Lo einnehmen kann.

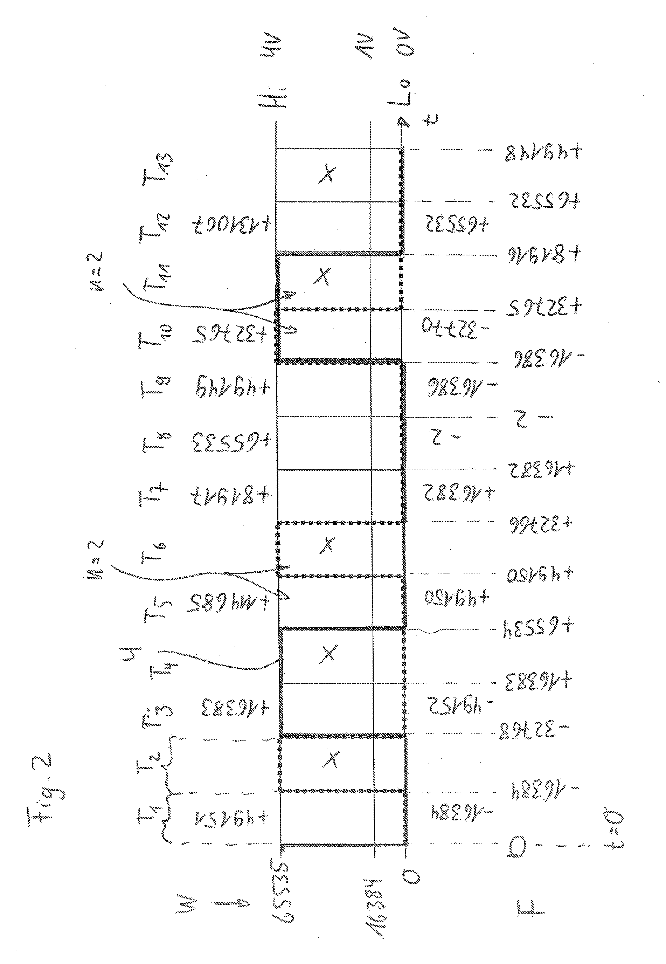

Durch ein nicht dargestelltes Filter wird der Bitstrom 4 in einen Analogwert A zurückgewandelt. Im Beispiel ist der Analogwert A eine Spannung zwischen 0V und 4V, welche insofern dem Digitalwert W entspricht, dass ein Digitalwert W=0 dem Analogwert 0V und ein Digitalwert 65535 dem Analogwert 4V entspricht. Der Delta-Sigma-Wandler 2 arbeitet nach dem erfindungsgemäßen Verfahren, welches anhand Fig. 2 erläutert wird.

Fig. 2 zeigt den Bitstrom 4, der vom Delta-Sigma-Wandler 2 ausgegeben wird. Der Bitstrom, der sich nach dem bekannten Delta-Sigma-Verfahren gemäß Fig. 4 bei gleichen Rahmenbedingungen ergibt, ist zum Vergleich nochmals gepunktet dargestellt. Der Bitstrom 4 ist in Taktzyklen T₁,... der jeweiligen gleichen Zyklusdauer T unterteilt und über der Zeit t dargestellt. Der Fehlerspeicher 6 ist zum gezeigten Beginn des Verfahrens leer, d.h. der bis dato integrierte Fehler F ist Null. Der Digitalwert W ist 16384, da der Delta-Sigma-Wandler 2 am Ende einen Analogwert A der Spannung 1V erzeugen soll. Außerdem findet zum gezeigten Zeitpunkt t=0 gemäß einem historischen Signalverlauf ein Signalwechsel des Signalzustandes von Hi nach Lo statt.

Der Delta-Sigma-Wandler 2 beginnt nun in wie oben erläuterter Weise zu entscheiden, ob er im ersten Taktzyklus T₁ einen Hi- oder Lo-Pegel im Bitstrom 4 erzeugen soll. Im Falle des Hi-Signals würde der Fehler F wie im obigen Beispiel 49151 betragen, im Falle des Lo-Signals -16384. Er wählt daher das Lo-Signal, so dass sich am Ende des Taktzyklus T₁ der Fehler im Fehlerspeicher 6 zu F=^{_}16384 aufintegriert. Im erfindungsgemäßen Verfahren ist nun vorgegeben, dass nach einem Wechsel des Signalzustandes mindestens die Anzahl n=2 Taktzyklen T ein weiterer Wechsel des Signalzustandes unterdrückt wird. Für den Taktzyklus T₂ ist daher der Signalzustand Lo bereits aus dem Taktzyklus T₁ festgelegt. Die fehlende Wahlmöglichkeit des Signalpegels gemäß des bekannten Delta-Sigma-Verfahrens ist durch ein Kreuz im betreffenden Taktzyklus T angedeutet. Es entsteht ohne Wahlmöglichkeit für den Delta-Sigma-Wandler 2 ein Fehler von ^{_}16384^{_}16384=^{_}32768.

Im Taktzyklus T₃ ist nun die erfindungsgemäße Unterdrückung des Wechsels des Signalzustandes beendet, so dass nun der Delta-Sigma-Wandler 2 wieder wie gewohnt entscheiden kann. Hier entscheidet er sich für den betragsmäßig kleineren Fehler bei Ausgabe eines Hi-Signals von +16383 gegenüber -49152 bei Ausgabe eines Lo. Da nun im Taktzyklus T₃ wieder ein Signalwechsel von Lo nach Hi stattgefunden hat, ist der Taktzyklus T₄ wieder erfindungsgemäß für Signalwechsel gesperrt, so dass sich der Fehler auf +65534 erhöht.

Erst im Taktzyklus T₅ besteht wieder Wahlmöglichkeit. Der Delta-Sigma-Wandler wählt das Lo-Signal, um den Fehler F auf den betragskleineren Wert von +49150 zu bringen. Der Takt T₆ ist erfindungsgemäß wieder gesperrt. Im Takt T₇ besteht wieder Wahlmöglichkeit. Hier bleibt jedoch der Signalpegel auf Lo bis zum Takt T₉, da sich hier entsprechend betragsmäßig niedrigere Fehlerwerte F ergeben.

Anzumerken ist hier, dass ab dem Takt T₇ die Sperrbedingung der Anzahl n=2 Taktzyklen bereits verstrichen ist. Somit könnte in jedem der folgenden Taktzyklen wieder ein Signalwechsel erfolgen.

Erst im Takt T₁₀ erfolgt zur Minimierung des Fehlers F wieder ein Wechsel auf den Hi-Pegel, Takt T₁₁ ist daher gesperrt. In Takt T₁₂ erfolgt ein erneuter Wechsel auf den Lo-Pegel, Takt T₁₃ ist wieder gesperrt. Zu erkennen ist im Bitstrom 4, dass also jeweils nur Hi- oder Lo-Pulse mit einer minimalen Pulsbreite von n=2 Taktzyklen auftreten können. Somit findet eine Art obere Frequenzbegrenzung statt.

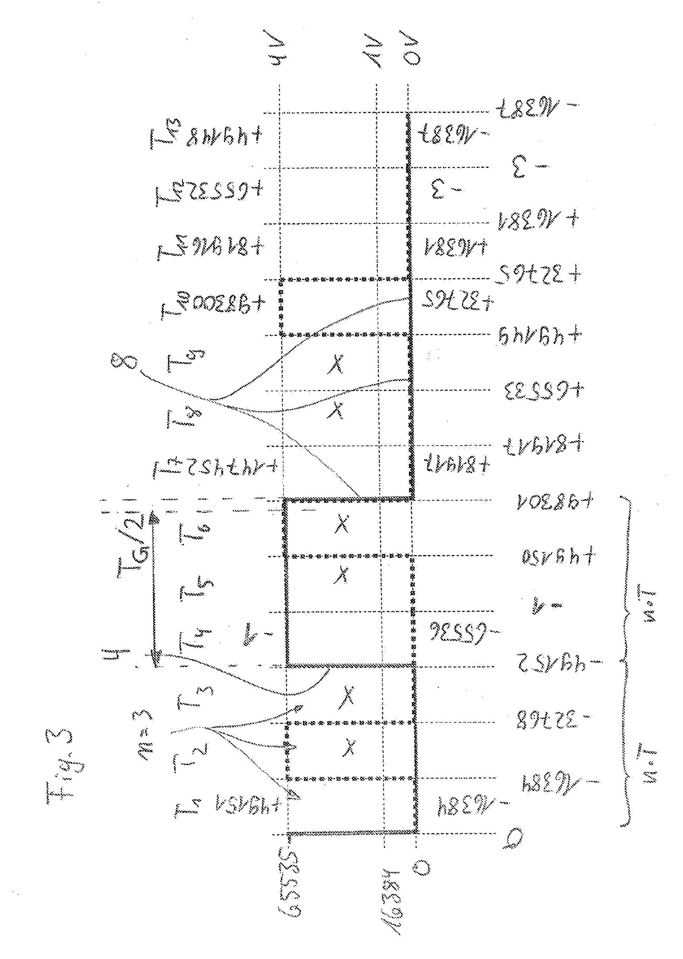

Fig. 3 zeigt eine alternative Ausführungsform des Delta-Sigma-Wandlers 2 mit einer Unterdrückung des Wechsels des Signalzustandes für n=3 Taktzyklen. Auch hier ist wieder der bekannte Bitstrom gemäß Fig. 4 zum Vergleich gepunktet dargestellt. Bei ansonsten gleichen Rahmenbedingungen wie in Fig. 2 besteht eine Wahlmöglichkeit für den Delta-Sigma-Wandler 2 zum Taktwechsel erst wieder im Taktzyklus T₄. Der Delta-Sigma-Wandler wechselt hier nach Hi, um den Fehler F im Fehlerspeicher 6 auf den Wert ^{_}1 zu bringen. Wegen des Signalwechsels sind die Takte T₄ bis T₆ wieder gesperrt für Signalwechsel. Erst im Takt T₇ kann wieder eine Entscheidung des Delta-Sigma-Wandlers zu einem Signalwechsel führen. Hier findet ein Signalwechsel zum Lo-Signal statt. Die Takte T₈ und T₉ sind wieder gesperrt. Ab dem Takt T₁₀ besteht wieder freie Wahlmöglichkeit für Taktwechsel, welche jedoch wegen des in Fig. 3 erkennbaren Fehlerverlaufs F nicht weiter erfolgen.

In Fig. 3 ist nochmals zu erkennen, dass der Bitstrom 4 gegenüber Fig. 4 eine dreifach längere minimale Pulsdauer n*T=3T besitzt. Der Bitstrom 4 wird in der Regel als analoges Zeitsignal bzw. Ausgangssignal 8, z.B. als zwischen zwei Werten wechselndes Spannungssignal ausgegeben. In Fig. 3 ist für das Ausgangssignal eine minimale Periodendauer T_{G} bzw. maximale Grenzfrequenz fg vorgegeben. Mit anderen Worten soll das Ausgangssignal 8 keine Signalwechsel in Zeitabständen kleiner der halben Periodendauer T_{G}/2 beinhalten. Die Anzahl n ist dann so gewählt, dass eine Anzahl n von Taktzyklen T eine kumulierte Dauer n*T, also eine minimale Pulsdauer im Ausgangssignal 8 ergibt, die größer oder gleich der halben minimalen Periodendauer T_{G}/2 ist.

Mit anderen Worten wird also die minimal zulässige Periodendauer T_{G} des Ausgangssignals 8 gewählt, und aus dieser und der Taktdauer T die Anzahl n bestimmt.

## Patentansprüche

1. Verfahren zum Betreiben eines Delta-Sigma-Wandlers (2), der einen mehrere Bit breiten Digitalwert (W) in Taktzyklen (T₁,...) in einen binäre Signalzustände (Lo,Hi) aufweisenden Bitstrom (4) wandelt, und die Signalzustände (Lo,Hi) in den Taktzyklen (T₁,...) nach einem Delta-Sigma-Verfahren mit integrierender Speicherung eines Restfehlers (F) gewählt werden, bei dem:
- nach jedem durch das Delta-Sigma-Verfahren verursachten Wechsel des Signalzustandes (Lo,Hi):
- ein eventueller weiterer, durch das Delta-Sigma-Verfahren geforderter Wechsel des Signalzustandes (Lo,Hi) für mindestens eine vorgebbare Anzahl (n) von mindestens zwei Taktzyklen (T₁,...) unterdrückt wird,
- der auflaufende Restfehler (F) weiter integriert wird.

2. Verfahren nach Anspruch 1, bei dem die vorgebbare Anzahl (n) von Taktzyklen (T₁,...) so gewählt wird, dass deren gemäß der Anzahl (n) kumulierte Dauer (T) mindestens der halben minimalen Periodendauer (T_{G}) eines aus dem Bitstrom (4) erzeugten analogen Ausgangssignals (8) beträgt.
